# DEMANDE DE BREVET EUROPEEN

(11) **EP 1 508 942 A1**
(43) Date de publication de la demande: **23.02.2005**
(21) Numéro de dépôt: 04354027.7
(22) Date de dépôt: 11.08.2004
(51) Int. Cl.: H01R 12/04

(54) **Dispositif de connexion électrique entre deux plaquettes et procédé de réalisation d'un composant microélectronique comportant un tel dispositif**

(30) Priorité: 21.08.2003 FR 0310070
(71) Demandeur: COMMISSARIAT A L'ENERGIE ATOMIQUE, 75752 Paris Cédex 15 (FR)
(72) Inventeur: Robert, Philippe, 38100 Grenoble (FR)
(74) Mandataire: Hecke, G.

(57) **Abrégé**

Un dispositif de connexion électrique (1) entre des première et seconde plaquettes (2, 3) comporte au moins des premier et second éléments de contact respectivement solidaires des faces opposées (2a, 3a) des première et seconde plaquettes (2, 3). Le premier élément de contact comporte une zone en saillie (6) tandis que le second élément de contact est constitué par une poutre (7) suspendue au-dessus d'une cavité (8) formée dans la seconde plaquette (3). La zone en saillie (6) a une largeur (L1) inférieure à la largeur (L2) de la cavité (8) et elle peut former un plot ou une nervure. Une fois les première et seconde plaquettes (2, 3) assemblées, la zone en saillie (6) et la poutre (7) entrent en contact au-dessus de la cavité (8) et la pression exercée par la zone en saillie (6) engendre une déformation de la poutre (7), la rendant souple.

## Description

### Domaine technique de l'invention

L'invention concerne un dispositif de connexion électrique entre des première et seconde plaquettes utilisées dans le domaine des microtechnologies, ledit dispositif comportant au moins des premier et second éléments de contact respectivement solidaires des faces opposées des première et seconde plaquettes et respectivement réalisés sous la forme d'au moins une couche mince, le premier élément de contact comportant une zone en saillie.

L'invention concerne également un procédé de réalisation d'un composant microélectronique comportant un tel dispositif de connexion électrique.

### État de la technique

Pour assembler deux plaquettes telles que celles utilisées dans le domaine de la microtechnologie et plus connues sous le nom de « wafers », tout en assurant une conduction électrique entre les deux plaquettes, il est courant de disposer des plots de contact entre les deux plaquettes. En effet, les plots de contact sont connus pour garantir une fiabilité maximale et une bonne résistance de contact.

A titre d'exemple, des plots de contact peuvent être disposés respectivement sur les faces opposées des deux plaquettes, de sorte qu'une fois les deux plaquettes assemblées, les plots de chaque plaquette viennent en contact avec les plots correspondant de l'autre plaquette. Cependant, les faces des plaquettes sur lesquelles sont disposés les plots de contact ne sont pas nécessairement planes, ce qui peut empêcher le contact entre deux plots correspondant. Les défauts de planéité d'une ou des deux plaquettes peuvent être dus, par exemple, à la présence d'inhomogénéités à la surface des plaquettes ou bien à la présence de butées de scellement ou de marches. Par exemple, la surface d'une des plaquettes peut avoir une certaine rugosité ou les surfaces des deux plaquettes peuvent être non complémentaires. De plus, de tels plots rigides ne permettent pas de déformation entre les plaquettes assemblées. En effet, une fois les plaquettes assemblées, elles peuvent subir des dilatations thermiques différentes qui engendrent un déplacement de chaque plaquette par rapport à l'autre plaquette, dans des directions opposées, les plots rigides ne permettant pas un tel déplacement.

Il est ainsi préférable de réaliser des connexions électriques souples entre les deux plaquettes de manière à ne pas s'opposer aux déplacements dus à une dilatation thermique et à compenser les défauts de planéités. Ainsi, dans le document « Sea of Leads Ultra High-Density Compliant Wafer-Level Packaging Technology » (2002 Electronic Component and Technology Conference), Muhannad S. Bakir et al. proposent de réaliser des contacts souples au moyen d'une membrane en polymère. La membrane en polymère forme un pont sur la surface d'une plaquette et elle est partiellement recouverte par une couche mince en or dont une extrémité est solidaire de la plaquette et dont l'autre extrémité comporte une bille de soudure destinée à assurer le contact avec une autre plaquette. L'emploi de ces contacts souples reste, cependant, limité. En effet, l'utilisation d'une membrane souple en matériau polymère limite l'utilisation des contacts ainsi réalisés à des températures supérieures à 200°C. De plus, ce type de contacts ne permet pas de réaliser un scellement des deux plaquettes jusqu'au contact mécanique, ce qui ne permet pas d'obtenir un scellement hermétique et/ou étanche. Enfin de tels contacts ne sont généralement pas faciles à réaliser, le procédé de fabrication étant fastidieux et coûteux.

### Objet de l'invention

L'invention a pour but de réaliser un dispositif de connexion électrique entre deux plaquettes, permettant de compenser les irrégularités des surfaces d'une ou des plaquettes, résistant à des températures supérieures à 200°C et permettant éventuellement de réaliser un scellement des deux plaquettes, tout en étant facile à mettre en oeuvre et en faisant, de préférence, appel à des techniques telles que celles utilisées dans le domaine de la microélectronique.

Selon l'invention, ce but est atteint par le fait que le second élément de contact est constitué par une poutre suspendue au-dessus d'une cavité formée dans la seconde plaquette, la zone en saillie ayant une largeur inférieure à la largeur de la cavité.

Selon un développement de l'invention, la première plaquette comporte une saillie sur laquelle est disposée une couche métallique de manière à former ladite zone en saillie.

Selon un mode de réalisation préférentiel, la poutre est constituée par une couche mince diélectrique recouverte par une couche mince métallique.

Selon un autre mode de réalisation, la poutre est constituée par une couche mince métallique.

L'invention a également pour but un procédé de réalisation d'un composant microélectronique comportant un tel dispositif de connexion électrique, fiable, peu coûteux, simple et pouvant, de préférence, être réalisé grâce aux technologies utilisées dans le domaine de la microélectronique.

Selon l'invention, ce but est atteint par le fait que le procédé consiste à assembler les première et seconde plaquettes en établissant une connexion électrique entre la zone en saillie du premier élément de contact et la poutre du second élément de contact, au-dessus de la cavité.

Selon un développement de l'invention, le procédé consiste à appliquer une couche isolante entre les première et seconde plaquettes assemblées, de manière à les sceller.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 est une vue en coupe d'un dispositif de connexion selon l'invention, sous forme éclatée.
La figure 2 représente, en coupe, un composant microélectronique comportant un dispositif de connexion selon l'invention, avec une zone en saillie ayant une épaisseur inférieure à l'épaisseur de la cavité.
La figure 3 représente, en coupe, un composant microélectronique comportant un dispositif de connexion selon l'invention, avec une zone en saillie ayant une épaisseur supérieure à l'épaisseur de la cavité.
La figure 4 représente, en perspective et sous forme éclatée, un mode particulier de réalisation d'un composant microélectronique comportant un dispositif de connexion selon l'invention.
Les figures 5 à 8 représentent, en coupe, différentes étapes de formation d'une première partie du dispositif de connexion selon la figure 1.
Les figures 9 à 11 représentent, en coupe, différentes étapes de formation d'une seconde partie du dispositif de connexion selon la figure 1.

### Description de modes particuliers de réalisation.

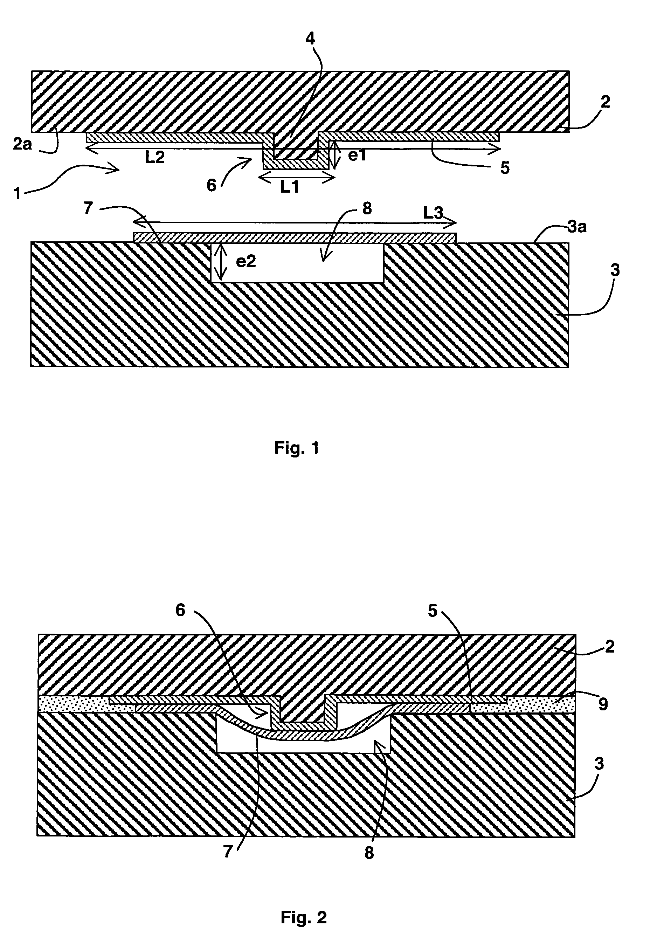

Comme représenté à la figure 1, dans un composant microélectronique comportant des première et seconde plaquettes 2 et 3, un dispositif de connexion électrique 1 comporte au moins des premier et second éléments de contact respectivement solidaires des faces opposées 2a et 3a des première et seconde plaquettes 2 et 3. Les premier et second éléments de contacts sont destinés à être mis en contact l'un avec l'autre pour assurer une connexion électrique lorsque les première et seconde plaquettes sont assemblées. Chaque plaquette 2 ou 3 peut être, par exemple, en silicium ou en verre. Ainsi, la première plaquette peut, par exemple, former un substrat sur lequel est disposé un circuit intégré tandis que la seconde plaquette peut être un substrat sur lequel est disposé un microsystème de type MEMS (« Micro Electro Mechanical System »).

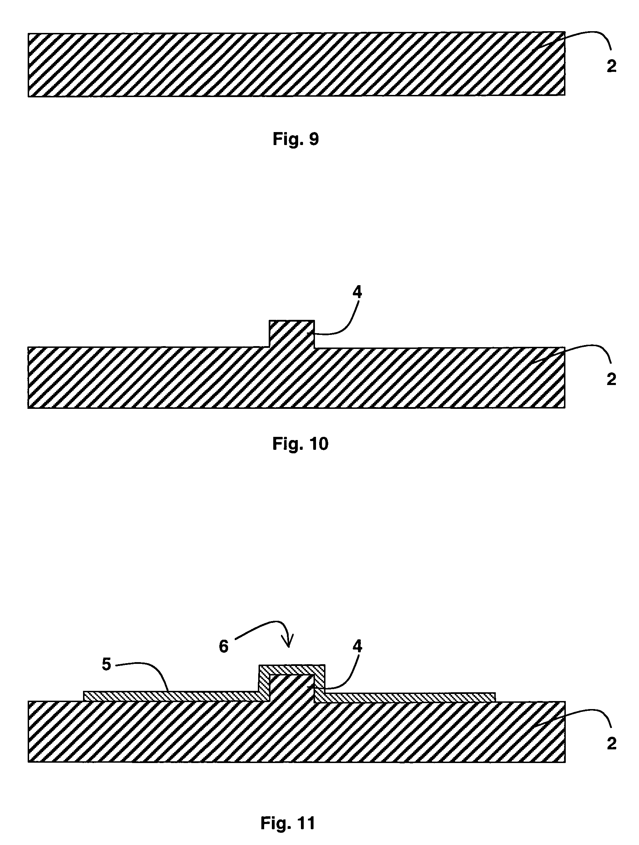

Ainsi, à la figure 1, la face 2a de la première plaquette 2 comporte une saillie 4 et une couche métallique 5 est disposée sur la face 2a, de manière à recouvrir la saillie 4 et à former une zone en saillie 6. La couche métallique 5 a, de préférence, une largeur L2 supérieure à la largeur L1 de la saillie 4, de sorte que les parties de la face 2a, adjacentes à la saillie 4, sont recouvertes par les extrémités de la couche métallique 5. La saillie 4 et la couche métallique 5 forment donc le premier élément de contact du dispositif de connexion. La zone en saillie 6 peut être sous la forme d'un plot ou d'une nervure. Ainsi, à titre d'exemple et comme représenté aux figures 9 à 11, le premier élément de contact peut être réalisé en gravant la saillie 4 sur la face 2a de la première plaquette 2 puis en déposant la couche métallique 5, qui peut être par exemple en or ou en aluminium, sur la face 2a. La forme du premier élément de contact est ensuite déterminée par une étape de lithogravure.

Le second élément de contact de la seconde plaquette 3 est constitué par une poutre 7 suspendue au-dessus d'une cavité 8 formée dans la seconde plaquette 3, la largeur L1 de la zone en saillie 6 étant inférieure à la largeur L2 de la cavité 8. Chacune des extrémités de la poutre 7 repose de part et d'autre de la cavité 8, sur la face 3a de la seconde plaquette 3. La poutre 7 est, de préférence, constituée par une couche mince métallique, par exemple en or ou en aluminium, ou par une couche mince diélectrique recouverte par une couche mince métallique.

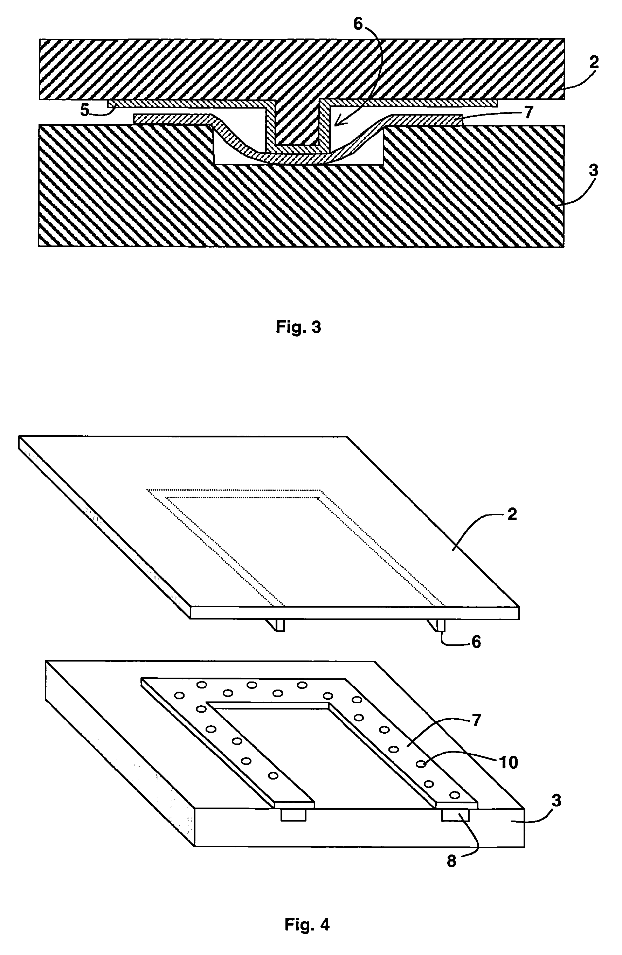

Ainsi, comme représenté aux figures 2 et 3, un tel dispositif de connexion permet de réaliser un composant microélectronique en assemblant les deux plaquettes 2 et 3 et en établissant un contact électrique entre la zone en saillie 6 et la poutre 7, au-dessus de la cavité 8. L'épaisseur de la poutre 7 étant suffisamment faible, elle peut se déformer sous la pression appliquée par la zone en saillie 6, au-dessus de la cavité 8. Ceci permet de former une connexion électrique souple, capable de compenser les éventuels défauts de planéité des plaquettes et autorisant la dilatation thermique des plaquettes en se déformant. En effet, selon l'épaisseur et la forme de la poutre 7 et selon la largeur de la zone en saillie 6, la pression exercée entre la zone en saillie et la poutre peut être ajustée. Ainsi, une poutre 7 relativement épaisse et ayant une largeur L3 assez faible a une raideur suffisamment importante pour créer une forte pression entre la zone en saillie et la poutre. De même, une zone en saillie 6 ayant une faible largeur L1 permet d'exercer une forte pression sur la poutre 7 ce qui favorise un contact avec une bonne résistance électrique. De plus, les faibles dimensions de la zone en saillie 6 permettent d'obtenir une forte densité de contact.

Un tel dispositif de connexion permet, lorsque l'épaisseur e1 de la zone en saillie 6 est inférieure à l'épaisseur e2 de la cavité 8, de réaliser le scellement des deux plaquettes. A titre d'exemple, l'épaisseur e2 de la cavité 8 peut être, par exemple, de 5 nanomètres tandis que l'épaisseur e1 de la zone en saillie 6 peut être de 3 nanomètres. Ainsi, comme illustré à la figure 2, une fois les plaquettes 2 et 3 assemblées, le contact est établi non seulement entre la zone en saillie 6 et la partie de la poutre 7 suspendue au-dessus de la cavité 8 mais également entre les extrémités de la couche métallique 5 et de la poutre 7. Le contact entre les extrémités de la couche métallique et de la poutre 7 permet donc de rendre la cavité 8 étanche. Une couche isolante 9, par exemple en polymère ou en oxyde, peut également être appliquée entre les deux plaquettes assemblées, de manière à sceller les plaquettes. Ce type de connexion permet, ainsi, de réaliser des composants microélectroniques encapsulés et sous vide tels que des microcapteurs résonants, tout en conservant la qualité du vide. Dans un autre mode de réalisation, représenté à la figure 3, l'épaisseur e1 de la zone en saillie 6 est supérieure à l'épaisseur e2 de la cavité 8 de sorte qu'une fois les deux plaquettes assemblées, seule la zone en saillie 6 est en contact avec la poutre 7. La poutre 7 se déforme, alors, sous la pression exercée par la zone en saillie, jusqu'à venir en contact avec le fond de la cavité 8. Une fois les première et seconde plaquettes assemblées, l'ensemble forme un composant microélectronique.

Un tel dispositif de connexion permet, non seulement, de former un contact électrique souple entre deux plaquettes, mais il permet également aux premier et second éléments de contact tout type de formes appropriées. Ainsi, comme illustré à la figure 4, la zone en saillie 6 du premier élément de contact peut être sous la forme d'une nervure de forme annulaire. La poutre 7 et la cavité 8 ont également une forme annulaire, de sorte que la zone en saillie 6 soit en contact avec la poutre 7 sur toute la longueur de la zone en saillie 6. La poutre 7 et la zone en saillie 6 peuvent avoir des longueurs comprises entre quelques dizaines de micromètres et quelques centaines de micromètres, ce qui augmente fortement la densité de contact. A la figure 4, des trous sont disposés dans la poutre 7, de manière à suspendre la poutre 7 au-dessus de la cavité 8 lors de la fabrication du second élément de connexion.

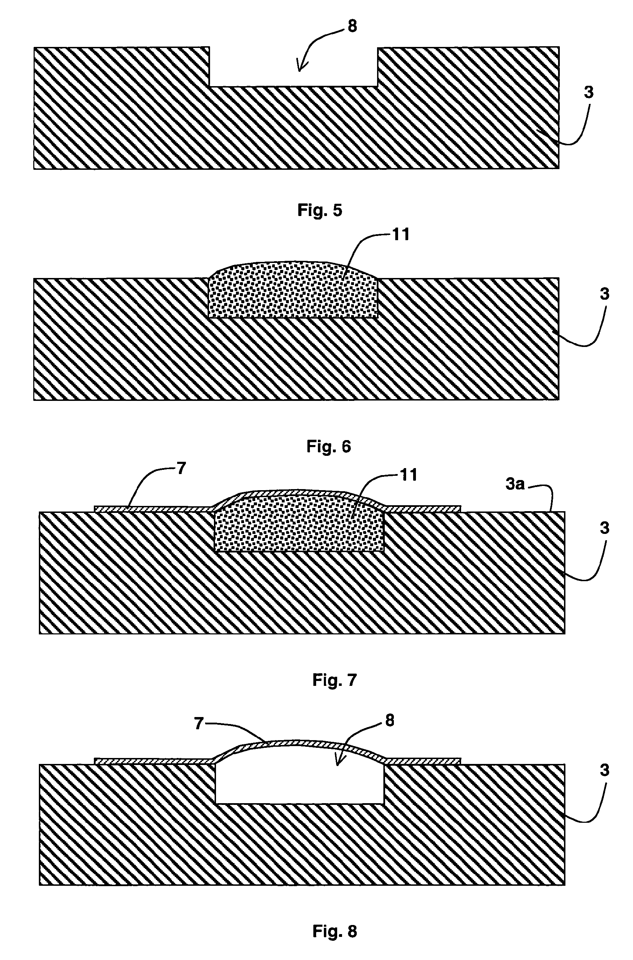

Ainsi, dans un mode particulier de réalisation représenté aux figures 5 à 8, la formation du second élément de connexion consiste à graver la seconde plaquette 3 pour former la cavité 8 (figure 5). Une couche sacrificielle 11, par exemple en polymère, est alors déposée, lithographiée et gravée dans la cavité 8 (figure 6) de manière à permettre le dépôt de la poutre 7 sous forme d'une couche mince métallique. La poutre 7 est donc ensuite déposée sur la couche sacrificielle 11 et sur les parties adjacentes de la face 3a de la plaquette 3 (figure 7). Puis, la forme de la poutre 7 est définie par une étape de lithographie et de gravure et les trous 10 sont formés dans la poutre 7 de manière à avoir accès à la couche sacrificielle 11 pour réaliser une gravure sèche permettant d'éliminer la couche sacrificielle 11 (figure 8). La poutre 7 est alors suspendue au-dessus de la cavité 8.

Un tel dispositif de connexion présente l'avantage de réaliser un contact électrique souple entre des première et seconde plaquettes, stable thermiquement, ce qui permet de réaliser des composants microélectroniques pouvant fonctionner à des températures supérieures ou égales à 200°C. Enfin, des tels composants microélectroniques sont faciles à réaliser, le procédé de réalisation pouvant être collectif, relativement peu coûteux et compatible avec les techniques utilisées dans le domaine de la microélectronique.

L'invention n'est pas limitée aux modes de réalisation décrits ci-dessus. Ainsi, le dispositif de connexion peut comporter une pluralité de premier et second éléments de contact. De plus, le dispositif de connexion peut permettre de relier électriquement deux composants individuels entre eux ou des composants présents sur une plaquette avec un autre composant. Il permet également de relier des circuits intégrés et/ou des microsystèmes entre eux, de façon collective, lorsqu'ils sont disposés sur des substrats. Le dispositif de connexion s'applique notamment à tout dispositif comportant un empilement de composants électroniques, comme un microsystème de type "MEMS" surmontant un circuit électronique, de manière à assurer un contact électrique entre les différents composants du dispositif.

## Revendications

1. Dispositif de connexion électrique entre des première et seconde plaquettes (2, 3) utilisées dans le domaine des microtechnologies, ledit dispositif (1) comportant au moins des premier et second éléments de contact respectivement solidaires des faces opposées (2a, 3a) des première et seconde plaquettes (2, 3) et respectivement réalisés sous la forme d'au moins une couche mince, le premier élément de contact comportant une zone en saillie (6), dispositif **caractérisé en ce que** le second élément de contact est constitué par une poutre (7) suspendue au-dessus d'une cavité (8) formée dans la seconde plaquette (3), la zone en saillie (6) ayant une largeur inférieure à la largeur de la cavité (8).

2. Dispositif selon la revendication 1, **caractérisé en que** la première plaquette (2) comporte une saillie (4) sur laquelle est disposée une couche métallique (5) de manière à former ladite zone en saillie (6).

3. Dispositif selon l'une des revendications 1 et 2, **caractérisé en ce que** la zone en saillie (6) forme un plot.

4. Dispositif selon l'une des revendications 1 et 2, **caractérisé en ce que** la zone en saillie (6) forme une nervure.

5. Dispositif selon l'une quelconque des revendications 1 à 4, **caractérisé en ce que** la poutre (7) est constituée par une couche mince diélectrique recouverte par une couche mince métallique.

6. Dispositif selon l'une quelconque des revendications 1 à 4, **caractérisé en ce que** la poutre (7) est constituée par une couche mince métallique.

7. Dispositif selon l'une quelconque des revendications 1 à 6, **caractérisé en ce que** la poutre (7) a une longueur comprise entre quelques dizaines de micromètres à quelques centaines de micromètres.

8. Dispositif selon l'une quelconque des revendications 1 à 7, **caractérisé en ce que** l'épaisseur (e1) de la zone en saillie (6) est inférieure ou égale à l'épaisseur (e2) de la cavité (8).

9. Dispositif selon l'une quelconque des revendications 1 à 7, **caractérisé en ce que** l'épaisseur (e1) de la zone en saillie (6) est supérieure à l'épaisseur (e2) de la cavité (8).

10. Procédé de réalisation d'un composant microélectronique comportant un dispositif (1) de connexion électrique selon l'une quelconque des revendications 1 à 9, **caractérisé en ce qu'**il consiste à assembler les première et seconde plaquettes (2, 3) en établissant une connexion électrique entre la zone en saillie (6) du premier élément de contact et la poutre (7) du second élément de contact, au-dessus de la cavité (8).

11. Procédé selon la revendication 10, **caractérisé en ce qu'**il consiste à appliquer une couche isolante (9) entre les première et seconde plaquettes assemblées (2, 3), de manière à les sceller.
